Europäisches Patentamt

European Patent Office

Office européen des brevets

(11) Publication number: **0 235 582**
A2

(12) # EUROPEAN PATENT APPLICATION

(21) Application number: 87101301.7

(22) Date of filing: 30.01.87

(51) Int. Cl.⁴: **B 30 B 15/06**, H 05 K 3/46

(30) Priority: 27.02.86 US 834697

(43) Date of publication of application: 09.09.87
Bulletin 87/37

(84) Designated Contracting States: CH DE FR GB IT LI NL

(71) Applicant: Hewlett-Packard Company, Mail Stop 20 B-O 3000 Hanover Street, Palo Alto California 94304 (US)

(72) Inventor: Marx, Martin J., 10206 Treeline, Boise Idaho, 83704 (US)

(74) Representative: Liesegang, Roland, Dr.-Ing., Sckellstrasse 1, D-8000 München 80 (DE)

(54) **Bonded press pad.**

(57) A reusable bonded press pad (1) suitable for use in the lamination of multilayer, flexible printed circuit boards is provided. The bonded press pad (1) comprises three separate layers of material bonded together: a sheet of resilient material (33) having a sheet of a release film (31, 35) bonded to each side with a suitable adhesive. The bonded press pad (1) reduces the surface adhesion between the press pad (1) and the packaging materials and minimizes static discharge encountered when breaking up the laminate package (10).

RELEASE FILM
1/8" SILICON RUBBER
RELEASE FILM

**Dr.-Ing. Roland Liesegang**

Patentanwalt
European Patent Attorney

Sckellstrasse 1
D-8000 München 80

Telefon (089) 4482496
Telefax (089) 4480433
Telex 5214382 pali d

HEWLETT-PACKARD COMPANY

Palo Alto, USA

EU 012 46

## BONDED PRESS PAD

### Background of the Invention

The present invention relates generally to the fabrication of multilayered and flexible printed circuit boards for the circuit board industry and specifically to reusable press pads utilized in the lamination process for multilayer and flexible printed circuit boards.

Multilayer printed circuit boards are fabricated utilizing a high temperature, high pressure lamination process. Typically, a multilayer sandwich composed of alternating layers of an insulating substrate material and electrically conductive metal foil, such as copper foil, is bonded together at high temperature under high pressure. A press pad is utilized in the lamination process to provide thermal conductivity and surface cushioning to buffer any movement of the materials being bonded during the lamination cycle. Movement of the materials is caused by differing rates of thermal expansion of the materials in the laminate sandwich. A buffer material is required to allow different

1

rates of thermal expansion between the inside of the lamination package and the outside of the lamination package during the curing or mechanical phase of the lamination process.

The forces generated during this movement cause the press pad to tightly adhere to the surfaces of the materials used in the lamination package, thus requiring great force to separate the press pad from the circuit board sandwich at the completion of the mechanical phase. Further a large static charge is accumulated on the surface of the press pad due to the movement of the materials during the mechanical phase and to stretching of the press pad during separation of the press pad and the separator plate. The accumulated static charge creates an electrical shock hazard to personnel.

The prior art press pads presently in use are reinforced with a fiberglass sheet in the center to reduce distortion during the separation process and increase the usable life of the press pad. However, the fiberglass material provides bonding sites at the tooling holes for excess adhesive used in the lamination process which may result in contamination of the circuit boards.

## Summary of the Invention

Accordingly, it is an object of the present invention to provide an improved press pad for use in the lamination of multilayer and flexible printed circuit boards having constant and uniform thermal conductivity and surface cushioning and which does not adhere to the packaging materials during the mechanical phase of the lamination process.

Another object of the present invention is to provide an improved press pad that is reusable over a long period of time without embrittlement or shrinkage.

In accordance with the above and other objects there is provided a reusable bonded press pad comprising three separate layers of material bonded together, one sheet of pad material having a sheet of a release film bonded to each side with a suitable adhesive. The present invention greatly reduces the surface adhesion between the press pad and the packaging materials thereby reducing the time and effort required to breakdown the laminate packages at the completion of the mechanical phase. The present invention also minimizes the static discharge encountered when using prior art press pads.

Other features and advantages of the invention will be apparent during the course of the following description.

## Brief Description of the Drawings

Figure 1 is a perspective view of a multilayer laminate package as prepared for the high temperature, high pressure mechanical phase of the printed circuit board fabrication process;

Figure 2 is a perspective view of a three-layer prior art press pad for use in the multilayer laminate package shown in Figure 1;

Figure 3a is a perspective view of a three-layer press pad according to the principles of the present invention; and

Figure 3b is a perspective view of the three-layer press pad shown in Figure 3b after bonding.

## Detailed Description of the Preferred Embodiment

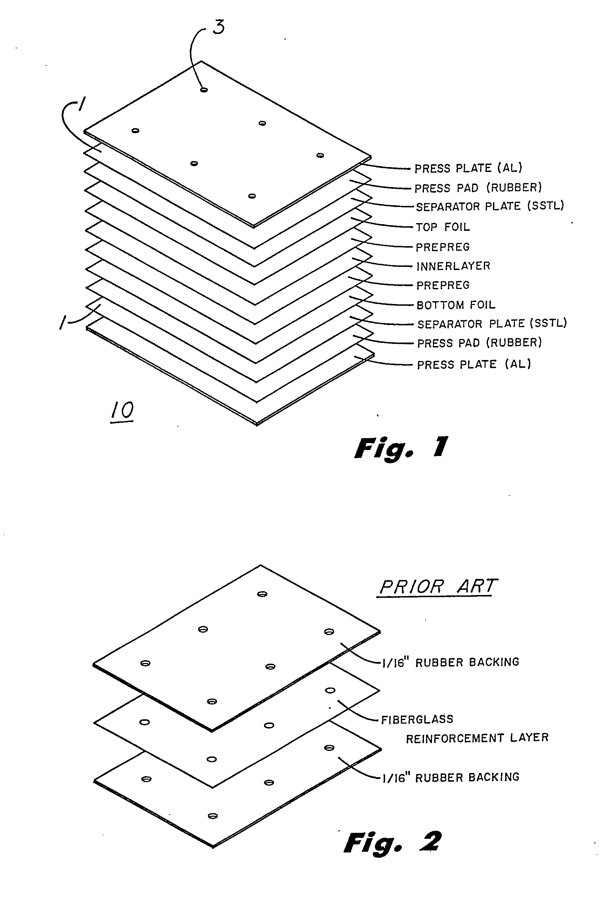

Referring now to Figure 1 of the drawings, an exploded view of a laminate package 10 is shown to illustrate the use of the present invention. The laminate package 10 is manually assembled in a layup area (not shown). Each of the components is pre-tooled with holes 3 to facilitate rigidly pinning the assembled package with retainer pins (not shown) to prevent slippage and misalignment between individual sheets during the curing process. The laminate package is made up as shown in Figure 1. A heavy press plate, typically of aluminum or other suitable metal, is laid down. Press pad 1 is then placed on top of the press plate and the pre-tooled holes 3 are aligned. The retainer pins (not shown) are then inserted through the pre-tooled plurality of holes 3 and the remaining components

4

that make up the laminate package are aligned on the retainer pins (not shown). The press pad is then covered by a thin metal separator plate, usually made of stainless steel. The desired number of sheets of electrically conductive metal foil and dielectric separators are alternately laid down to build up the desired circuit board. A second separator plate, press pad 1, and press plate are then placed on top of the stack to complete the laminate package. More than one circuit board can be assembled in the laminate package, merely requiring that the board assemblies be separated by stainless steel separator plates. The dielectric separators are impregnated with bonding resin (a material with the tradename "prepreg" is a suitable material for this purpose).

The laminate package 10 is then cured in a mechanical press (not shown) at a temperature of $300^{\circ}$ - $400^{\circ}F$ ($150^{\circ}$ - $205^{\circ}C$) and a pressure of 60 - 70 psi for a period of 40 - 60 minutes. During the curing process, the bonding resin flows around the sheets of foil and substrate, then sets thereby bonding the components of the circuit board together. At the completion of the curing cycle, the laminate package is removed from the press to a breakdown area where the retainer pins are knocked out and the laminate package broken up. The laminated circuit boards are passed to the next cycle in the process and the press plates, press pads and separator plates are reused.

5

Due to the extreme temperatures and high pressures required during the curing cycle, the press pad tightly adheres to the other components of laminate package thus requiring great force to separate and break apart the laminate package at the completion of the curing process. Further, slight movements of the components due to unequal thermal expansion of the components during the curing cycle and the sliding movement and stretching of the press pad relative to the other components during breakup of the laminate package cause the press pad to accumulate static charge which presents an extreme electrical shock hazard to personnel.

Referring now to Figure 2, an exploded view of a prior art press pad is shown. Typically, the prior art press pad is composed of a fiber glass reinforcement layer having one-eighth inch rubber backing on each side. The press pad is used either alone or in combination with a release film (not shown) which is inserted between the press plate and the press pad and between the press pad and the separator plate. Use of the press pad in combination with the release film results in some reduction of surface adhesion of the press pad. However, no reduction in the accumulated static charge occurs.

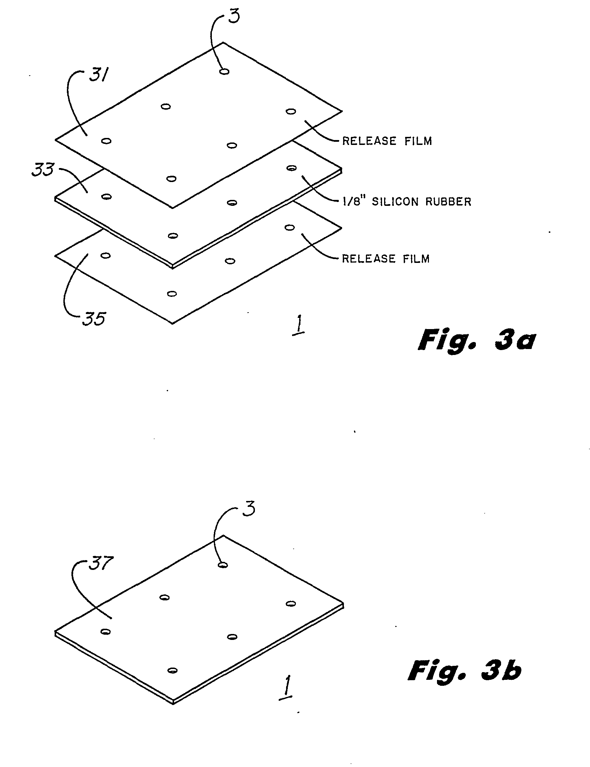

Referring now to Figures 3a and 3b, an exploded view of a bonded press pad 1 according to the principles of

6

the present invention is shown. The bonded press pad 1 comprises a press pad 33 of suitable material having a sheet of a release film 31 and 35 bonded to each side of the press pad. The press pad 33 is composed of a resilient material having uniform and high thermal conductivity that is able to hold its characteristics under extreme heat and pressure with no material deformation over the lifetime of the press pad (silicon rubber is a suitable material for this purpose). [The release film 31, 35] is [a] Mylar or any similar material which high-temperature resistant [material that] and can endure high pressures without embrittlement or shrinkage may be utilized as the release film 31, 35. Necessary characteristics of the release film 31, 35 include easy and unrestricted release from metal foils, press plates and impregnated dielectric separators and that it be inert to minimize oxidation and contamination of other components in the laminate package (PACOTHANE™ release film, manufactured by the Paper Corporation of the United States, is a suitable material for this purpose). The release film 31, 35 is bonded to the press pad 33 with a suitable adhesive; when using silicon rubber for the press pad 33 material, a silicon base adhesive is a suitable adhesive for bonding the release film 31, 35 to the press pad 33. The bonding of the release film to the press pad allows the use of existing, readily available materials which, when used separately, do not meet the desired criteria for a press pad, but when bonded together, satisfactorily meets all the criteria of no surface adhesion, no

7

static charge accumulation and no deformation of the press pad over the lifetime of the press pad.

The bonding process for the bonded press pad is comprised of several steps. Since all of the presently available materials required to make up the bonded pad are subject to shrinkage, it is necessary to pre-shrink the bonded press pad materials prior to bonding. The release film 31, 35 and the press pad are cut to a size slightly greater than the desired size to compensate for any shrinkage. The bonded press pad components are baked in an oven at a high temperature for pre-shrinking. The amount of time that the material is baked is inversely proportional to the temperature. The release film 31, 35, for example, is baked at a temperature of about 300°F (150°C) for one hour to pre-shrink it. One side of press pad 33 is coated with bonding adhesive (not shown) and the pre-shrunk release film 31 is applied to the press pad 33. The other side of the press pad 33 is the coat with bonding adhesive and the pre-shrunk release film 35 is applied. The bonding adhesive is then allowed to cure at room temperature and atmospheric pressure. When the adhesive has cured, tooling holes 3 are punched in the bonded release pad 33 (as shown in Figure 3b) to complete the fabrication process.

## Claims

1. A bonded press pad (1) for use in the lamination of multilayered printed circuit boards and the like having two sheets (31,35) of a release film and a planar press pad (33) of a predetermined size and shape having two flat sides, characterized in that one of said two sheets (31,35) of release film is permanently bonded to each one of said two flat sides of said press pad (33).

2. A bonded press pad (1) according to Claim 1, characterized in that said bonded press pad (1) includes a plurality of holes (3) through said press pad (33) and through said two sheets (31,35) of release film bonded thereto.

3. A method of fabricating a bonded press pad (1) for use in the lamination of printed circuit boards and the like said method comprising the steps of cutting a planar press pad (33) to a first predetermined size and shape, said planar press pad (33) having two flat sides, cutting two sheets (31,35) of a release film to a second predetermined size and shape geometrically similar to said first predetermined size and shape, characterized by pre-shrinking said planar press pad (31) and said two sheets (31,35) of release film, applying an adhesive coating to one of said two sides of the pre-shrunk press pad (31), applying one of said two sheets (31,35) of pre-shrunk release film to the coated side of the pre-shrunk press pad (31), applying an adhesive

9

coating to the other side of the pre-shrunk press pad (31), applying the other one of said two sheets (31,35) of pre-shrunk release film to the other coated side of the pre-shrunk press pad (31), and curing said adhesive.

4. A method according to Claim 3 characterized in that said step of pre-shrinking said planar press pad (31) comprises baking said planar press pad (31) at a first predetermined temperature for a first predetermined period of time, and said step of pre-shrinking said two sheets (31,35) of release film comprises baking said two sheets (31,35) of release film at a second predetermined temperature for a second predetermined period of time.

5. A method according to Claim 3 or 4 characterized by punching a plurality of holes (3) through said cured bonded press pad (1).

PRESS PLATE (AL)
PRESS PAD (RUBBER)
SEPARATOR PLATE (SSTL)
TOP FOIL
PREPREG
INNERLAYER
PREPREG
BOTTOM FOIL
SEPARATOR PLATE (SSTL)
PRESS PAD (RUBBER)
PRESS PLATE (AL)

10

**Fig. 1**

PRIOR ART

1/16" RUBBER BACKING

FIBERGLASS
REINFORCEMENT LAYER

1/16" RUBBER BACKING

**Fig. 2**

2|2

31
3

RELEASE FILM

33

1/8" SILICON RUBBER

RELEASE FILM

35

1

***Fig. 3a***

3

37

1

***Fig. 3b***